(19) Europäisches Patentamt
European Patent Office
Office européen des brevets

(11) Publication number: **0 099 558**
**A2**

(12) # EUROPEAN PATENT APPLICATION

(21) Application number: 83106961.2

(22) Date of filing: 15.07.83

(51) Int. Cl.³: C 23 F 1/00
H 01 L 21/31

(30) Priority: 22.07.82 US 400771
23.07.82 US 401196
26.07.82 US 402000

(43) Date of publication of application:
01.02.84 Bulletin 84/5

(84) Designated Contracting States:
DE FR GB NL

(71) Applicant: TEXAS INSTRUMENTS INCORPORATED
13500 North Central Expressway
Dallas Texas 75265(US)

(72) Inventor: Purdes, Andrew J.
2005 Glenbrook Meadows
Garland Texas 75040(US)

(74) Representative: Leiser, Gottfried, Dipl.-Ing. et al,
Patentanwälte Prinz, Bunke & Partner Ernsberger Strasse 19
D-8000 München 60(DE)

(54) **Fast plasma etch for aluminum.**

(57) An anisotropic plasma aluminum etch process uses a mixture of chlorine and recombinant, e.g. silicon tetrachloride plus boron trichloride. Etching is performed with an organic resist mask in place, although a hard masking layer may be emplaced underneath the resist. By providing a relatively high flow rate of the recombinant and a relatively low flow rate of chlorine at a relatively high total pressure, good anisotropy without undercutting is attained at reasonably high etch rates. A source of $CF_3$ radicals is optionally also introduced, to suppress corrosion.

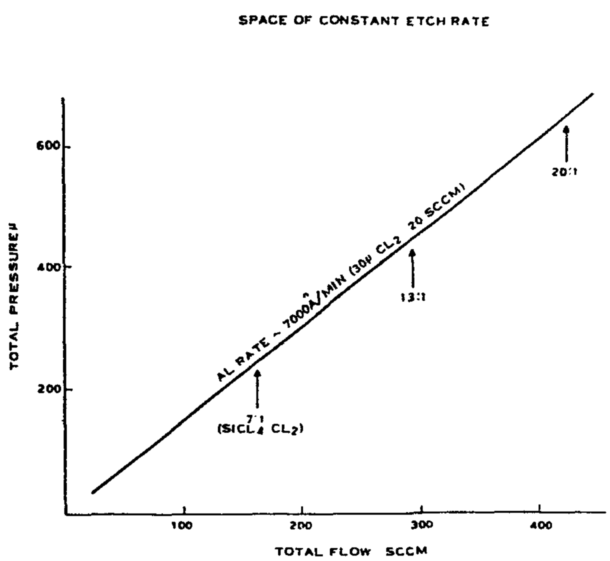


FIG. 6

EP 0 099 558 A2

Croydon Printing Company Ltd.

# FAST PLASMA ETCH FOR ALUMINUM

## BACKGROUND OF THE INVENTION

The present invention relates to a method for etching thin films of aluminum.

Electrical discharges in halogen bearing gases are now commonly used to etch materials for semiconductor device manufacture. A patterned masking material, such as photoresist, is used to uncover a desired pattern of the material to be etched. This "plasma etch" technique is especially valuable for defining small geometries.

Two problems commonly associated with plasma etching are (1) slow vertical etch rate and (2) lateral etching beneath the photoresist ("undercutting"). The latter problem is especially troublesome when very small geometries are desired. In particular, during plasma etching of aluminum it is often found that high vertical etch rates are accompanied by a large degree of undercutting.

Extremely low pressure etching will accomplish aluminum etching with minimal undercut. However, such systems (so-called reactive ion etch, or "RIE" systems) are intrinsically limited to very low etching rates. Thus, to use such a configuration in a production environment, a multi-slice batch system must be used. However, slice-to-slice uniformity now becomes a great problem. Since aluminum will etch in chlorine, even when no plasma has been created, the flow patterns of the etchant gas are critical. Moreover, large many-slice batch systems are not easily amenable to automation, because of slice-handling and process flow difficulties.

Thus it is an object of the present invention to provide a method for rapidly etching aluminum films with minimal undercutting.

It is a further object of the invention to provide a method for etching aluminum which provides a high vertical etch rate and a low lateral etch rate.

U.S. Patent No. 4,256,534 to Levinstein et al teaches

a combination of chlorine and boron trichloride for aluminum etching. The boron trichloride aids in the removal of the native oxide layer and acts as a "recombinant" which serves to reduce lateral etching. The recombinant is believed to preferentially react with Cl atoms which absorb on the aluminum sidewalls, thus preventing lateral etching; this recombination process is suppressed by ion bombardment at the horizontal etched surfaces. Increasing the percentage of chlorine in the gas flow increases both the vertical etch rate and the undercut. Typical anisotropic etch rates are less than 100 nanometers per minute.

Thus, it is an object of the present invention to provide an anisotropic aluminum etch having an etch rate substantially greater than 100 nanometers per minute.

SUMMARY OF THE INVENTION

The present invention specifies a process for etching aluminum, using a mixture of chlorine plus a recombinant gas. The chlorine is the principal active etching ingredient, and the recombinant gas promotes anisotropy. The partial pressure of chlorine is selected to provide the desired vertical etch rate, and the pressure of the recombinant gas is separately selected to adequately suppress undercutting. Preferably the flow rate of the recombinant gas is at least 10 times that of the chlorine.

According to the present invention, there is provided:

a method for etching aluminum films, comprising the steps of:

providing a surface;

providing a uniform layer of aluminum on said surface;

providing a patterned layer of masking material on said aluminum film;

flowing a gaseous mixture at a total pressure of at least 700 microns over said aluminum film, said gaseous mixture comprising chlorine and a recombinant gas, wherein the flow rate of said recombinant gas is at least 10 times the flow rate of said chlorine; and

applying an electrical discharge through said gaseous mixture.

BRIEF DESCRIPTION OF THE DRAWINGS

The present invention will be described with reference to the accompanying drawings, wherein:

Figure 1 shows a single slice reactor such as is preferably used in practicing the present invention;

Figure 2 shows the relation between aluminum etching rate and partial pressure of chlorine in a silicon tetrachloride plus chlorine etchant gas mixture;

Figure 3 shows the dependence of aluminum etching rate on chlorine flow under flow-limited etching conditions;

Figure 4 shows the dependence of aluminum etching rate on chlorine pressure under chlorine impingement limited etching conditions;

Figure 5 shows the relation of aluminum etching rate to total flow, at a given partial pressure of chlorine, for two different power levels;

Figure 6 shows different values of total pressure and total flow, which may be selected to achieve a nominally constant aluminum etching rate;

Figure 7 shows the relation of aluminum etching rate to chlorine partial pressure, in the presence of admixtures of silicon tetrachloride or of boron trichloride;

Figure 8 shows the effect of an inert diluent gas used to partially replace the silicon tetrachloride in a silicon tetrachloride-chlorine gas mixture;

Figure 9 shows the dependence of aluminum etching rate on chlorine pressure at two different power levels; and

Figure 10 shows a section of a patterned aluminum structure being formed by the process of the present invention.

DESCRIPTION OF THE PREFERRED EMBODIMENTS

Figure 1 shows the reactor configuration which is presently used to practice the presently preferred embodiment of the invention, as will be further discussed below. However, a large variety of other reactor configurations are alternatively used. In the configuration of Figure 1, a four-inch wafer 12 is shown supported on a six-inch electrode (substrate holder) 14, to which an RF power supply 16 is connected. A grounded electrode 18 is opposed to the substrate holder 14. The grounded electrode 18 is spaced about one-half inch from the surface of wafer 12. Process optimization will be described below in terms of flow rates and RF power levels for this particular reactor, and the translation of these parameters so that they can be used for other reactor configurations will then be discussed.

Figure 2 shows the dependence of the aluminum etching rate on the partial pressure of chlorine. Note that for a given total flow rate the aluminum etching rate is quite linearly dependent on the partial pressure of chlorine. In the present invention, various gas mixtures are taught, but the primary active etchant is always chlorine. For a fixed total gas flow, the vertical aluminum etch rate is determined by the chlorine partial pressure defined as:

$$P_{Cl_2} = \frac{F(Cl_2)}{F(Cl_2 + SiCl_4)} P_{total} \qquad (1)$$

Pressure of chlorine equals flow of chlorine over flow of (chlorine and silicon tetrachloride), times total pressure, where F refers to respective gas flows. For a

fixed value of the pressure of chlorine, the etch rate also increases with the total gas flow at pressures below 400 microns. This is shown by the data points indicated by squares at 35 microns of chlorine pressure in Figure 2.

For a given total gas flow, equation (1) shows that there are an unlimited number of chlorine flow and total pressure combinations which will result in the same value of chlorine partial pressure. This implies that essentially the same aluminum etch rate can be obtained under many different conditions. The present invention teaches that increasing the ratio of total flow to chlorine flow reduces undercutting. The silicon tetrachloride appears to act as a recombinant, like boron trichloride. It is apparent from equation (1) that high aluminum etch rate (high chlorine partial pressure) and low undercut can only be achieved at low values of (chlorine flow over total flow) and high total pressure. Table 1 indicates actual results demonstrating this teaching of the present invention, as measured in the reactor configuration of Figure 1. One micron thick aluminum films on a silicon wafer 12 were used for etch testing. The RF power was maintained at 150 watts. Etch rate and completion were determined by monitoring the 261 nm AlCl emission line. Etch conditions were maintained for one minute past the completion of the etch. The results in Table I were measured with a total gas flow of 200 standard cubic centimeters per minute (sccm) and a chlorine partial pressure of 60 microns. As discussed above, the aluminum etch rate is not very sensitive to the total pressure, at constant chlorine partial pressure. However, the amount of undercut rapidly decreases as the pressure is increased. Thus providing a high total pressure, at a given chlorine partial pressure, minimizes undercut. Note that the degree of undercutting was sometimes measured to be greater than the one micron aluminum film thickness, which is believed to be the result of continued erosion of aluminum beneath the photomask after the unmasked aluminum had been cleared.

TABLE 1

| Total Pressure (microns) | $Cl_2$ Flow (sccm) | $SiCl_4$ Flow (sccm) | Al Rate (Angstrom/ Min) | Undercut (microns) |
|---|---|---|---|---|
| 500 | 24 | 176 | 6250 | 5 |
| 750 | 16 | 184 | 5000 | 1 |
| 1000 | 12 | 188 | 5000 | 0.5 |

In similar tests, using boron trichloride rather than silicon tetrachloride, a one minute overetch results in severe undercutting. A silicon tetrachloride-chlorine mixture is therefore more suitable than a boron trichloride chlorine mixture for high-rate aluminum etching with minimal undercut.

However, boron trichloride-chlorine discharges are more stable than those formed in silicon tetrachloride-chlorine. Discharge stability (i.e. uniformity of current in space and time) is highly desirable for ensuring a uniform etch condition over the whole wafer. Particularly at pressures above 400 microns, the discharge stability permitted by a $BCl_3$ addition is highly desirable.

To improve discharge stability, while also controlling undercutting, the present invention also teaches a mixture of boron trichloride, chlorine, and silicon tetrachloride for aluminum etching. Table II shows the results of a test of this embodiment of the invention, together with tests under other conditions for comparison. Total pressure is 1,000 microns in all cases.

TABLE II

| Power (W) | $Cl_2$ Flow (sccm) | $SiCl_4$ Flow (sccm) | $BCl_3$ Flow (sccm) | Al Rate (Angstrom/ min) | Results |
|---|---|---|---|---|---|
| 150 | 18 | 282 | 0 | 4444 | Undercut 0.5 micron |
| 150 | 18 | 0 | 282 | -- | Undercut 10 microns |
| 150 | 18 | 100 | 182 | 5000 | Undercut 0.5 micron |
| 100 | 18 | 100 | 182 | -- | Undercut 10 microns |

These tests show that a mixture of silicon tetrachloride, boron trichloride, and chlorine can give minimal undercut, like that of a silicon tetrachloride and chlorine mixture, but with improved discharge stability.

However, as the the fourth run in Table II shows, an extreme sensitivity to RF power also appears. This is interpreted as follows. When silicon tetrachloride is introduced into the discharge, reactions like the following occur:

$$SiCl_4 + \varepsilon^- \rightarrow SiCl_3 + Cl + \varepsilon^-$$

$$SiCl_3 + \varepsilon^- \rightarrow SiCl_2 + Cl + \varepsilon^-$$

$$SiCl_2 + \varepsilon^- \rightarrow SiCl + Cl + \varepsilon^-$$

It is the fragments of silicon tetrachloride (silicon trichloride, dichloride, or monochloride radicals produced by the above reactions) which are believed to be responsible for suppressing undercut. At higher power and higher ratios of silicon tetrachloride to chlorine, the density of silicon tetrachloride fragments will be increased.

A second cause of power sensitivity is the organic photoresist (such as AZ1450) which is preferably left in place during aluminum etching. It is known that gas evolved from the resist has a favorable effect on suppressing sidewall undercut, although the reason for this is not clear. It is believed that the hydrogen gas evolved is primarily responsible. At higher power, a greater degree of resist bombardment takes place, and therefore more gas is evolved from the resist, leading to greater sidewall passivation.

The minimum power levels are discussed above in terms of watts, but peak voltage supplied by the wafer is a parameter which is more easily translatable between different reactor configurations. Thus, 150 watts in this example translates to 200 volts peak. (In calculating peak voltage, it should be noted that there is not only an RF component, but usually also a DC component present.)

Table III shows the effect of varying total pressure while maintaining the ratio of (silicon tetrachloride and boron trichloride) to chlorine at a constant value of 15.7 to 1. Table III shows that the aluminum etch rate was relatively constant from 1000 to 500 microns, but decreased at 250 microns. While the degress of undercut was minimal at all pressures, the stability and uniformity of the discharge was improved at the lower pressures.

TABLE III

| Pressure (microns) | Al Rate (Angstrom/ min) | Comments |
|---|---|---|
| 1000 | 3809 | Undercut 0.5 micron |
| 750 | 3809 | " |
| 500 | 4000 | " |
| 250 | 2963 | " |

(Power = 150W, $Cl_2$ = 18 sccm, $SiCl_4$ = 100 sccm, $BCl_3$ = 182 sccm)

Even the boron trichloride plus silicon tetrachloride plus chlorine mixture described above still suffers from two problems: (1) undercutting of small isolated resist structures, and (2) post etch corrosion of the aluminum. In a further embodiment of the present invention, a small amount of monobromotrifluoromethane is used to solve these problems. It is believed that the discharge dissociates the monobromotrifluoromethane into atomic bromine and trifluoromethane radicals, which react to form a passive aluminum fluoride layer.

Table IV shows the results of several tests demonstrating the effectiveness of this embodiment of the invention.

TABLE IV

| $Cl_2$ Flow (sccm) | $CBrF_3$ Flow (sccm) | Al Rate (Angstrom/ min) | Undercut | Corrosion |
|---|---|---|---|---|
| 20 | 0 | 5000 | 0.5 | Started after 2 hours |
| 20 | 5 | 5000 | " | None |
| 20 | 10 | 5263 | " | None |
| 30 | 7.5 | 6666 | " | Began to corrode after removal from reactor |
| 30 | 15 | 6250 | " | Began to corrode after removal from reactor |

(Power = 200W, pressure = 500 , $SiCl_4$ = 100 sccm, $BCl_3$ = 200 sccm)

From Table IV we can see that there are many combinations of $Cl_2$ and $CBrF_3$ flows that are effective for preventing undercutting. It should be emphasized that the undercut in Table IV refers to small (about 2 micron), isolated resist features. At the higher $Cl_2$ flow (30 sccm) the etch rate is increased but this is accompanied by an increased susceptibility to post-etch corrosion. For $CBrF_3$:$Cl_2$ ratios of 1/4 to 1/2, the vertical aluminum etch rate is little affected by the $CBrF_3$ addition. As this ratio becomes larger than 1:1, the vertical aluminum etch rate can be reduced - the amount of reduction being determined by pressure, power, and other process parameters.

It should be appreciated that other gases such as $CF_4$, $CF_3Cl$, $CF_3H$ and $C_2F_6$ - all of which can be dissociated to produce $CF_3$ radicals - may also be usefully employed for passivating the aluminum sidewall. The preferred concentrations of these gases are, however,

expected to differ from the $CBrF_3$ case.

The presently preferred embodiment of the invention uses the following parameters: boron trichloride, 134 sccm; silicon tetrachloride, 66 sccm; chlorine 12.5 sccm; and $CBrF_3$, 6.25 sccm; 400 microns pressure; 200 watts RF power, at a wafer to electrode spacing of 1/2 inch. This results in an aluminum etch rate of 300 nanometers per minute. In view of the discussion above, it will be apparent that this is a conservative etch application of the present invention.

It is also possible to add diluent gases, such as helium. However, adding any diluent to the preferred embodiments of the present invention results in faster etch and greater undercutting.

A further degree of control over power level is provided by an adaptive control procedure. Since the silicon tetrachloride fractions are not only responsible (in part) for suppressing undercutting, but also are responsible for cutting through the native aluminum oxide layer, the initiation time can be used to pre-characterize the etch. That is, by monitoring the 261 nm line of the AlCl radical, as discussed above, onset of aluminum etching can be detected. The time until this onset has occurred indicates the activity of silicon tetrachloride fractions, and therefore indicates the degree to which those fractions will be available for sidewall passivation. If the initiation time is too long, the power level must be raised before actual etching begins. In the preferred embodiment of the present invention, using the reactor shown in Figure 1, the initiation time is expected to be about ten seconds. If a longer initiation time occurs, the power level is immediately raised proportionately. This adaptive control procedure works best with mixtures which contain boron trichloride.

The characteristics of the patterned resist layer which is used to pattern the aluminum are critical. If the resist profile is particularly good (i.e. if the actual patterned resist structure has vertical sidewalls), a faster etch can be used. Since resist erosion normally occurs during the etch, vertical sidewalls in the resist mean that resist erosion will not degrade the patterning.

An excessively high total flow rate is limited by the importance of the evolved resist products, as discussed above. If the total flow rate is too high, the resist products will be swept away from the etching sites and will not perform their desired role in passivation.

A hard mask for patterning, such as TiW, is preferable for line width control. However, as noted, drastic undercutting is noted when the etch of the present invention is used without organic resist in place. Therefore, the presently preferred embodiment performs aluminum etching while a patterned resist layer is in place atop a patterned hard mask layer on the Al.

Attempts have been made to compensate for the absence of resist products, where only a hard mask is used, by adding a polymerizing agent, such as carbon tetrachloride, to the gas flow, but this is an inherently dirty process, which will deposit polymers everywhere in the etch chamber. By contrast, the gases evolved from the resist are localized.

A TiW hard mask also reduces reflection, to help the original optical patterning of the photoresist layer. Since TiW will begin to oxidize after a few days in the air, it is quite desirable not to leave TiW exposed for long. Instead, after the aluminum etching step has been performed, the resist is ashed and the TiW is removed using a carbontetrafluoride plus oxygen post etch.

The etch of the present invention results in selectivities of around 4:1 over polysilicon and around 15:1 over thermal oxide.

Thus, the present invention permits good anisotropy of etching with substantially higher etch rates than are normally possible using low pressure processes (so-called

reactive ion etching). Since nonuniformity of gas flow will result in nonuniform etching, the present invention is preferably practiced using a single slice etcher. The present invention preferably uses a mixture of chlorine and silicon tetrachloride for etching. In alternative embodiments, boron trichloride and/or a small percentage of additional halocarbon are also added.

Table V shows the effect of various parameters discussed above on line width reduction.

TABLE V

PARAMETRIC DEPENDENCE OF LINEWIDTH REDUCTION

| | | | |
|---|---|---|---|
| Power | 150 | 250 | Watts |
| Pressure | 400 | 800 | Microns |
| Spacing | 0.5 | 1.5 | Inch |
| Flow | 200 | 400 | Sccm |
| % $SiCl_4$ | 0.33 | 0.66 | |

Line Loss = 2.2
+ 0.37 x Flow
- 0.29 x % $SiCl_4$
+ 0.42 x Pressure x Power
- 0.66 x Flow x Pressure

As noted, higher power results in less undercutting. Higher power will also increase the volatilization of polymer precursers, which will aid in passivating the aluminum sidewalls (i.e. undercutting will be reduced). This polymerization will be inhibited by the concurrent presence of $Cl_2$. There will, thus, be a competition between sidewall passivation and undercutting, depending on the relative partial pressures of the polymer precursers and $Cl_2$. The partial pressure of polymer precursers will be determined by the type fo resist, the resist pattern coverage and the process power. This last variable, power, is the only one we can easily control. We previously discussed that a high ratio of

$(SiCl_4+BCl_3):Cl_2$ is desirable to prevent undercutting. For a given power, the partial pressure of polymer precursers will be constant. The relative partial pressures of polymer precursers:$Cl_2$ will then be totally controlled by the total flow of gas and the partial $Cl_2$ flow. Thus, lower gas flows do indeed result in less undercutting.

A presently preferred embodiment uses a power density of 1 W/cm$^2$ and a gas flow of 200 sccm. To scale these conditions to another reactor the power density should be kept nominally at 1W/cm$^2$. Our reactor's gas flow uses a "shower head" feed arrangement, distributing the gas over an 80 cm$^2$ area. The gas flow impinging per unit of area of etched surface is 2.5 sccm/cm$^2$. To first order, this gas glow density, 2.5 sccm/cm$^2$, should scale well to other reactors.

Improved sidwall passivation will result from either higher power density or lower gas flow density. As the power is increased greatly, however, the linewidth control of all lines will be controlled by resist erosion. The aluminum will not be undercut, but the aluminum line will still be narrower than desired.

The parameter ranges useful in practicing the present invention include, among others:

1. A chlorine partial pressure of at least 10 microns, at a total pressure of at least 200 microns in a gas mixture consisting only of chlorine and silicon tetrachloride.

2. A chlorine flow of at most 16 standard cc per minute, in a gas mixture where the total pressure is at least 600 microns.

3. Using a mixture of boron trichloride, silicon tetrachloride, and chlorine, where the ratio of total flow to chlorine flow is at least 10:1.

4. Using a mixture of silicon tetrachloride, boron trichloride, and chlorine, where RF power is applied at a peak voltage of at least 200 volts.

5. Using a mixture of silicon tetrachloride, boron trichloride, and chlorine, where the ratio of total flow

to chlorine flow is at least 10:1, and the total pressure is less than 600 microns. Using a mixture of chlorine plus a chloride (boron trichloride or. silicon tetrachloride) plus an admixture of a halocarbon which can dissociate to form a trifluorocarbon radical, wherein the flow rate of chlorine is between two and four time the flow rate of the trifluorocarbon-radical-forming species.

6. Using a mixture of chlorine and silicon tetrachloride, where the total flow is at least 10 times the flow of chlorine.

Thus, the present invention advantageously provides

a method for rapidly etching aluminum films with minimal undercutting;

a method for etching aluminum which provides a high vertical etch rate and a low lateral etch rate; and

an anisotropic aluminum etch having an etch rate substantially greater than 100 nanometers per minute.

CLAIMS

WHAT I CLAIM IS:

1. A method for etching aluminum films, comprising the steps of:

providing a surface;

providing a uniform layer of aluminum on said surface;

providing a patterned layer of masking material on said aluminum film;

flowing a gaseous mixture at a total pressure of at least 700 microns over said aluminum film, said gaseous mixture comprising chlorine and a recombinant gas, wherein the flow rate of said recombinant gas is at least 10 times the flow rate of said chlorine; and

applying an electrical discharge through said gaseous mixture.

2. The method of Claim 1, wherein said gaseous mixture comprises a gas selected from the group consisting of silicon tetrachloride, boron trichloride, phosphorus trichloride, chlorinated methane, and chlorinated ethane.

3. The method of Claim 1, wherein said electric discharge step comprises applying a peak voltage of at least 200 volts to said aluminum film.

4. The method of Claim 1, wherein said electric discharge step comprises applying a power of at least one watt per square centimeter to said surface.

5. The method of Claim 1, wherein said gaseous mixture is flowed at a total pressure of at least 200 microns.

6. The method of Claim 1, wherein the partial pressure of chlorine is at least 10 microns.

7. The method of Claim 1, wherein the partial pressure of chlorine is at least 10 microns.

8. The method of Claim 1, wherein said gaseous mixtures further comprises a trifluorocarbon-radicalforming species.

9. The process of Claim 8, wherein said chlorine is flowed at a rate which is between 2 and 4 times the flow rate of the trifluorocarbon-radical-forming species.

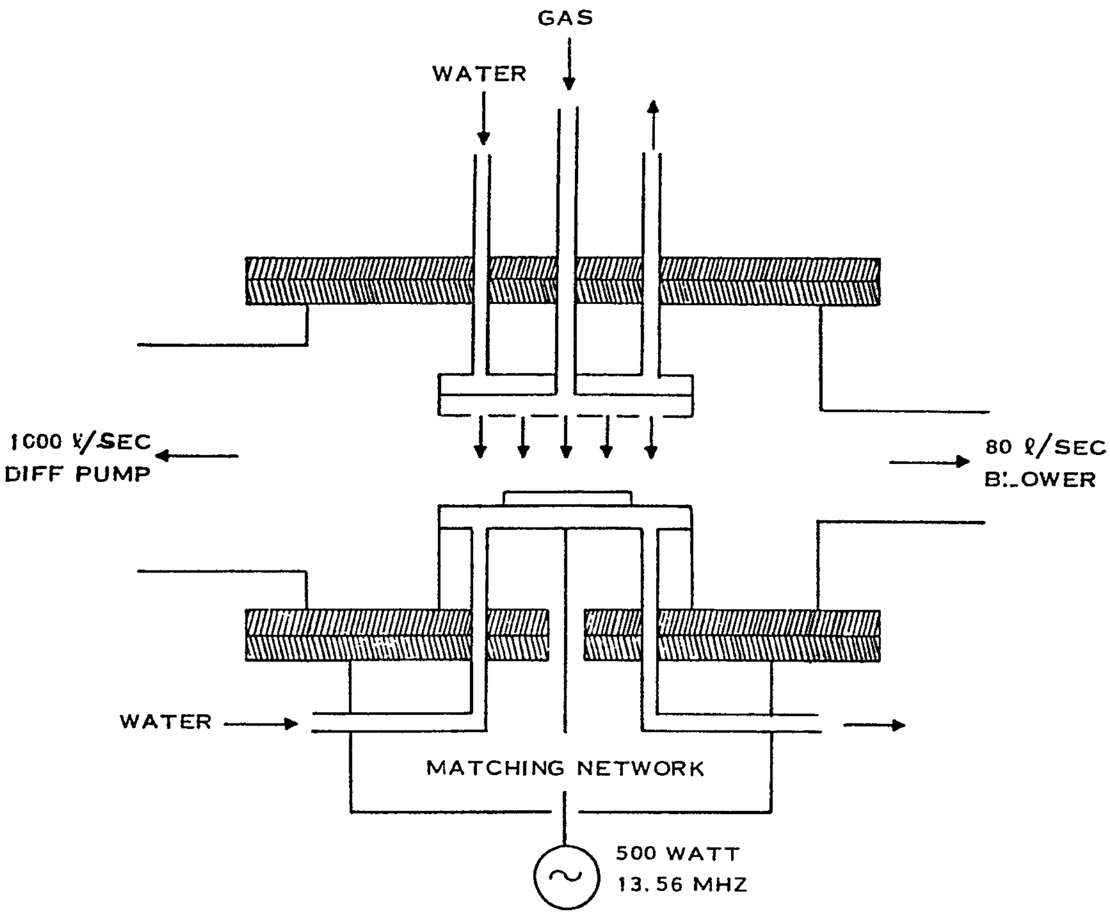
GAS
WATER
1000 ℓ/SEC
DIFF PUMP
80 ℓ/SEC
BLOWER
WATER
MATCHING NETWORK
500 WATT
13.56 MHZ

FIG. 1

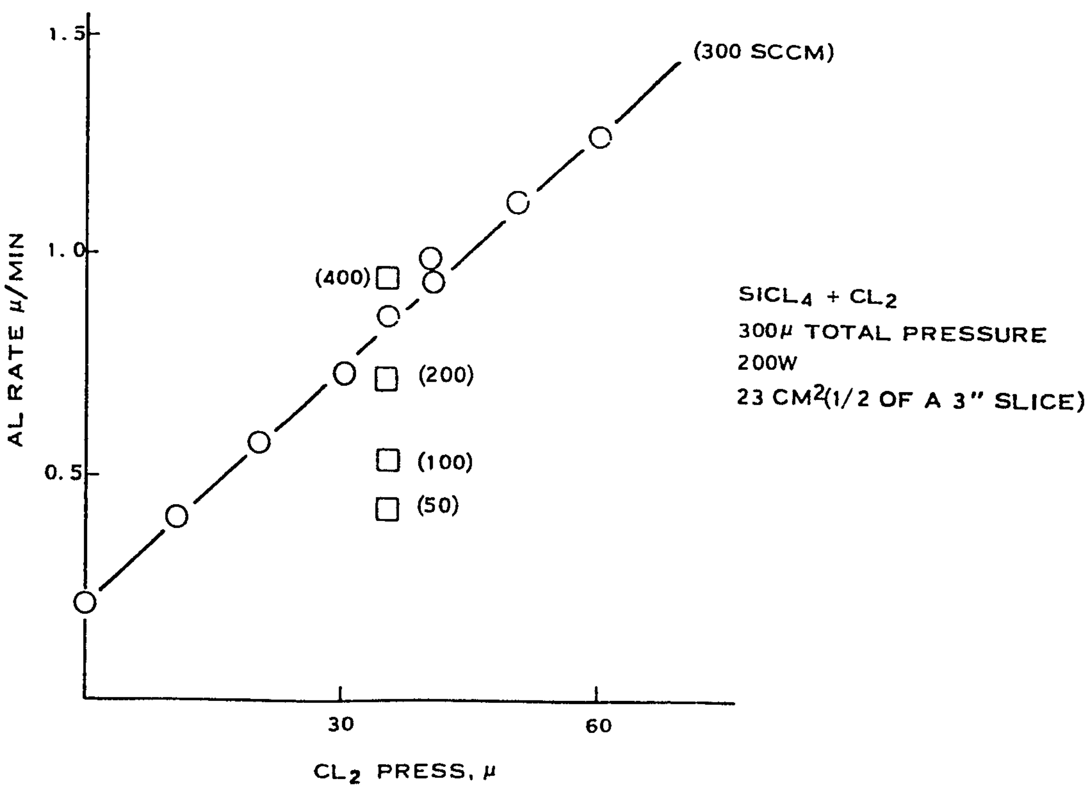
1.5
1.0
0.5
AL RATE μ/MIN
(300 SCCM)
(400)
(200)
(100)
(50)
SICL4 + CL2
300μ TOTAL PRESSURE
200W
23 CM2(1/2 OF A 3" SLICE)
30
60
CL2 PRESS, μ

FIG. 2

FLOW LIMITED AL ETCH RATE

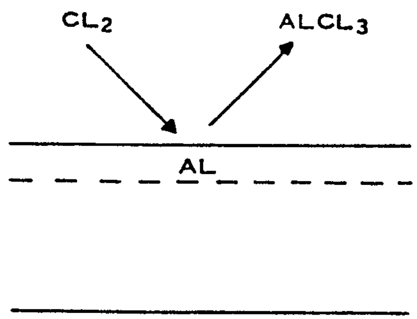


$CL_2$ FLOW $\left(\frac{SCCM}{CM^2}\right) = 3.4 \times 10^{-5}$ R

R = AL ETCH RATE (A MIN)

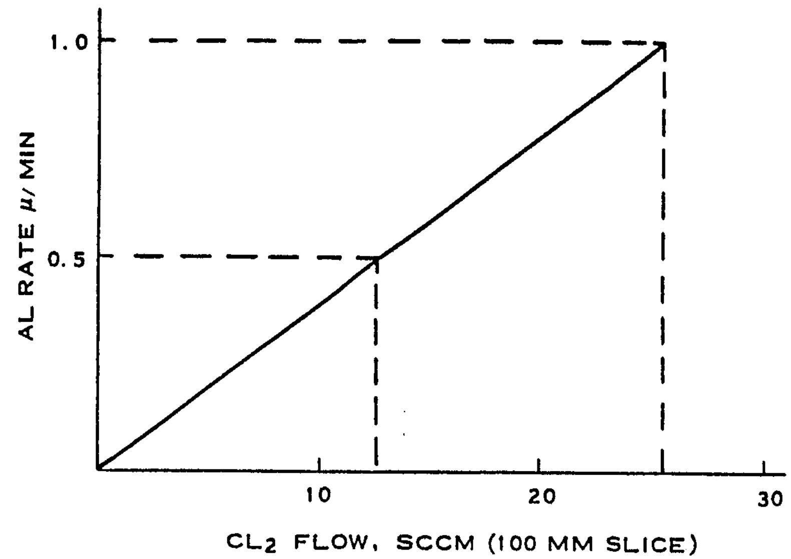


FIG.3

$CL_2$ IMPINGEMENT LIMITED AL ETCH RATE

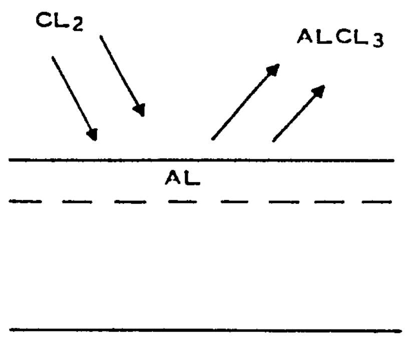


FLUX $(CL_2) = 2.6 \times 10^{17}$ PRESS $(\mu CL_2)$

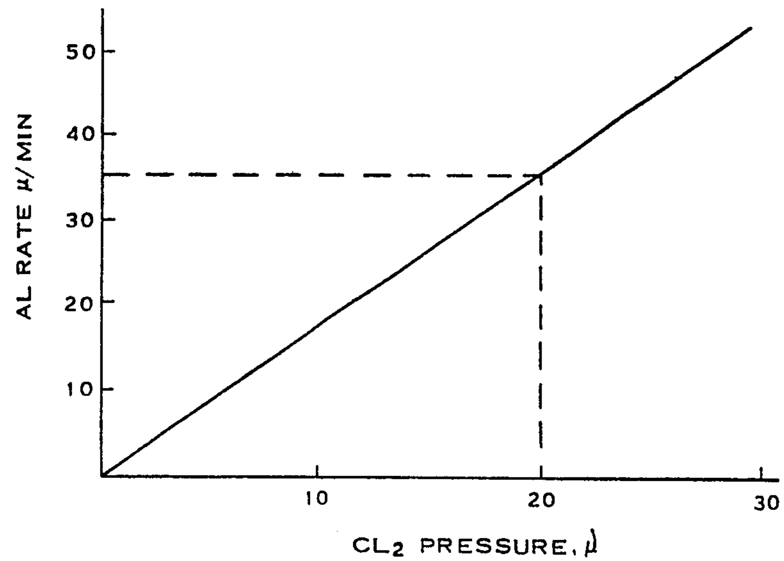


*FIG.4*

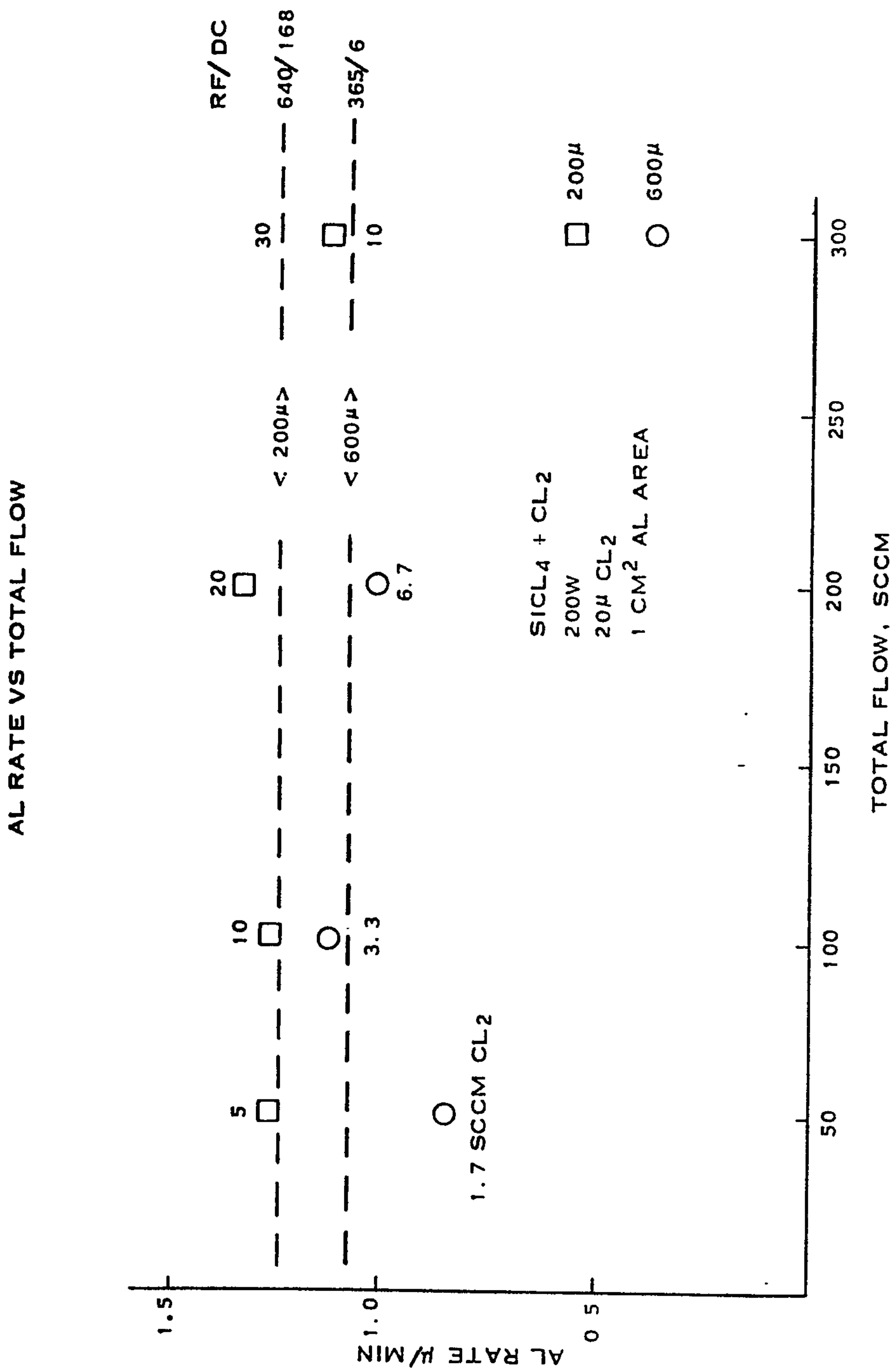
AL RATE VS TOTAL FLOW
RF/DC
640/168
365/6
< 200μ >
< 600μ >
5
10
20
30
3.3
6.7
10
1.7 SCCM CL2
SICL4 + CL2
200W
20μ CL2
1 CM2 AL AREA
200μ
600μ
AL RATE μ/MIN
1.5
1.0
0.5
50
100
150
200
250
300
TOTAL FLOW, SCCM

FIG.5

SPACE OF CONSTANT ETCH RATE

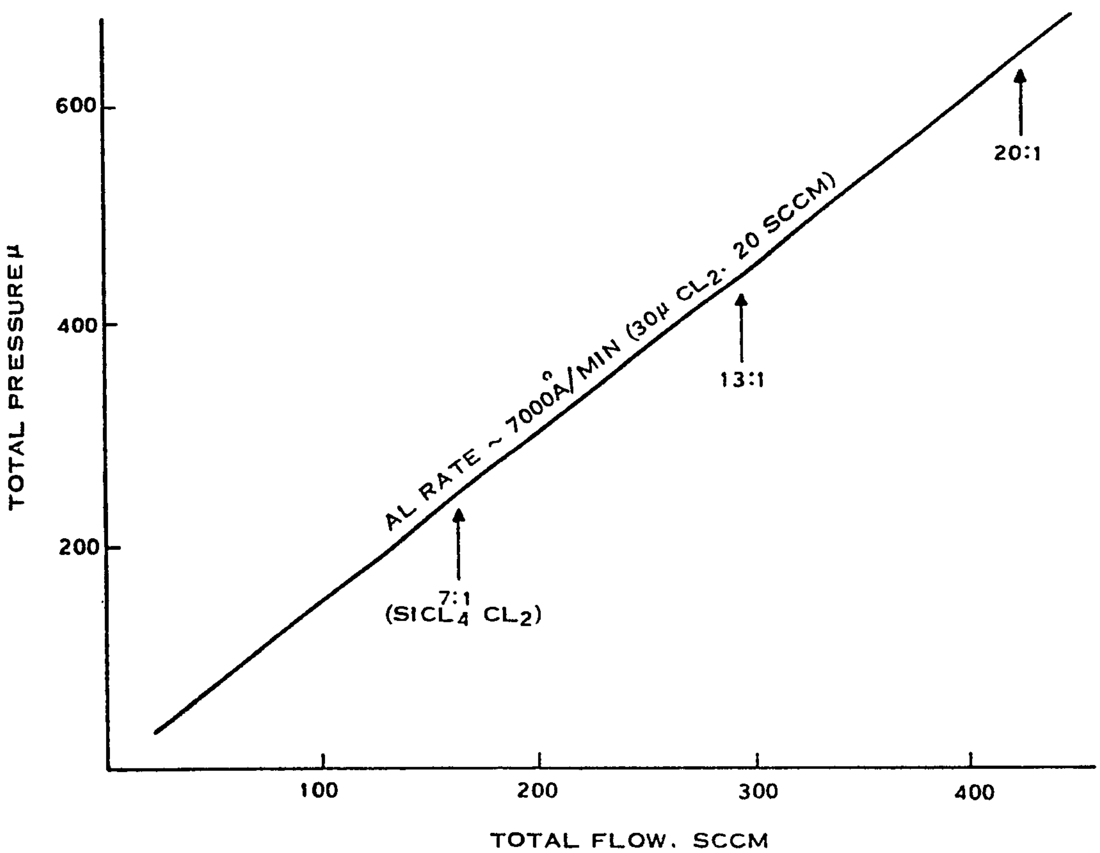


FIG. 6

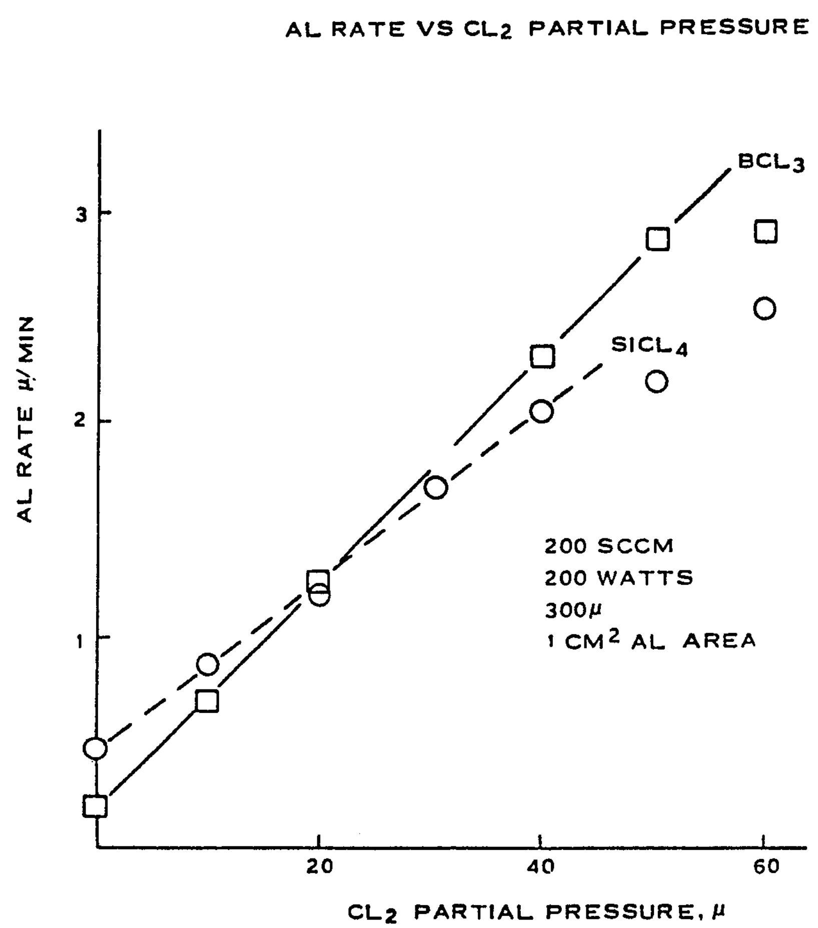
AL RATE VS CL2 PARTIAL PRESSURE
AL RATE μ/MIN
1
2
3
BCL3
SICL4
200 SCCM
200 WATTS
300μ
1 CM2 AL AREA
20
40
60
CL2 PARTIAL PRESSURE, μ

FIG. 7

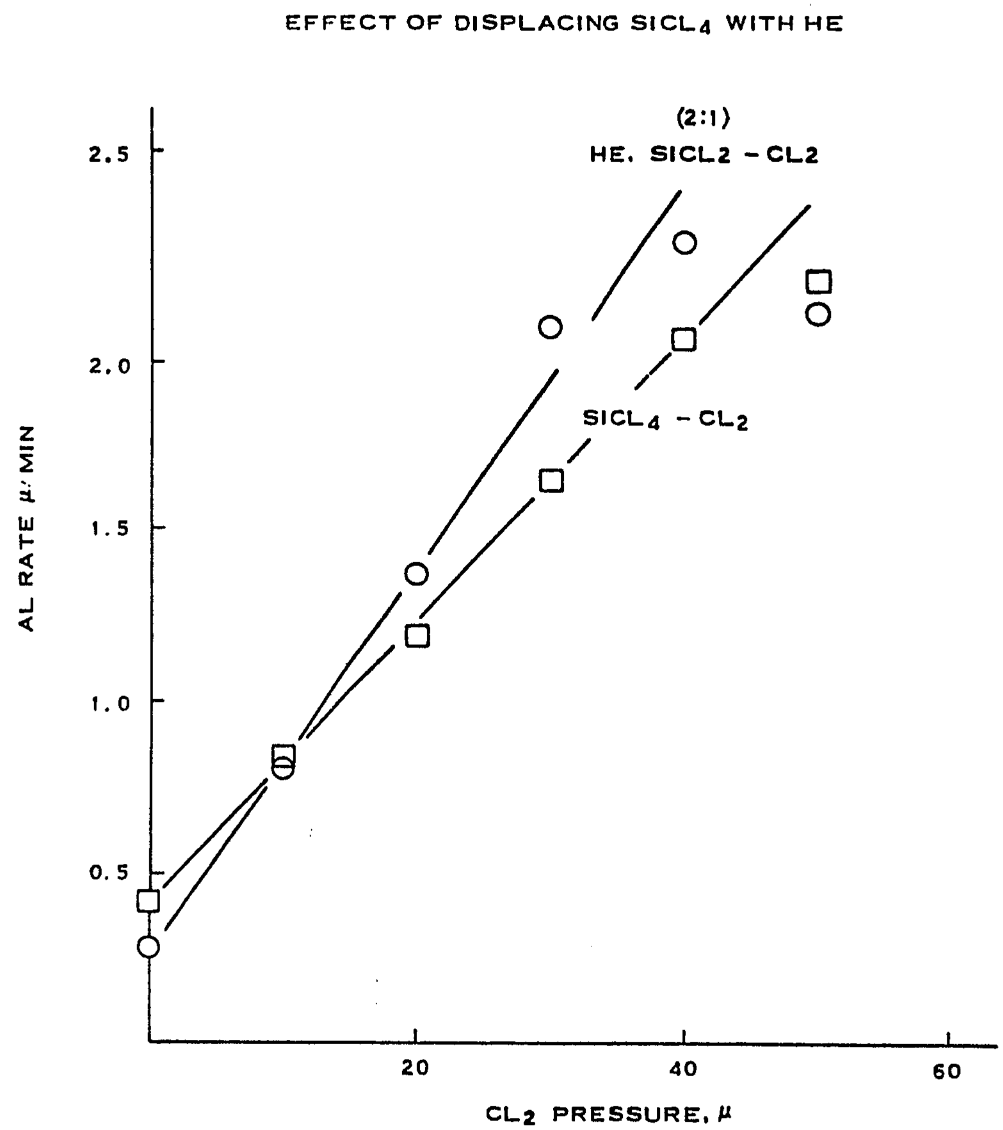
EFFECT OF DISPLACING SICL4 WITH HE
(2:1)
HE, SICL2 - CL2
SICL4 - CL2
AL RATE μ/MIN
0.5
1.0
1.5
2.0
2.5
20
40
60
CL2 PRESSURE, μ

FIG. 8

AL RATE VS $CL_2$ PRESSURE FOR TWO POWER LEVELS

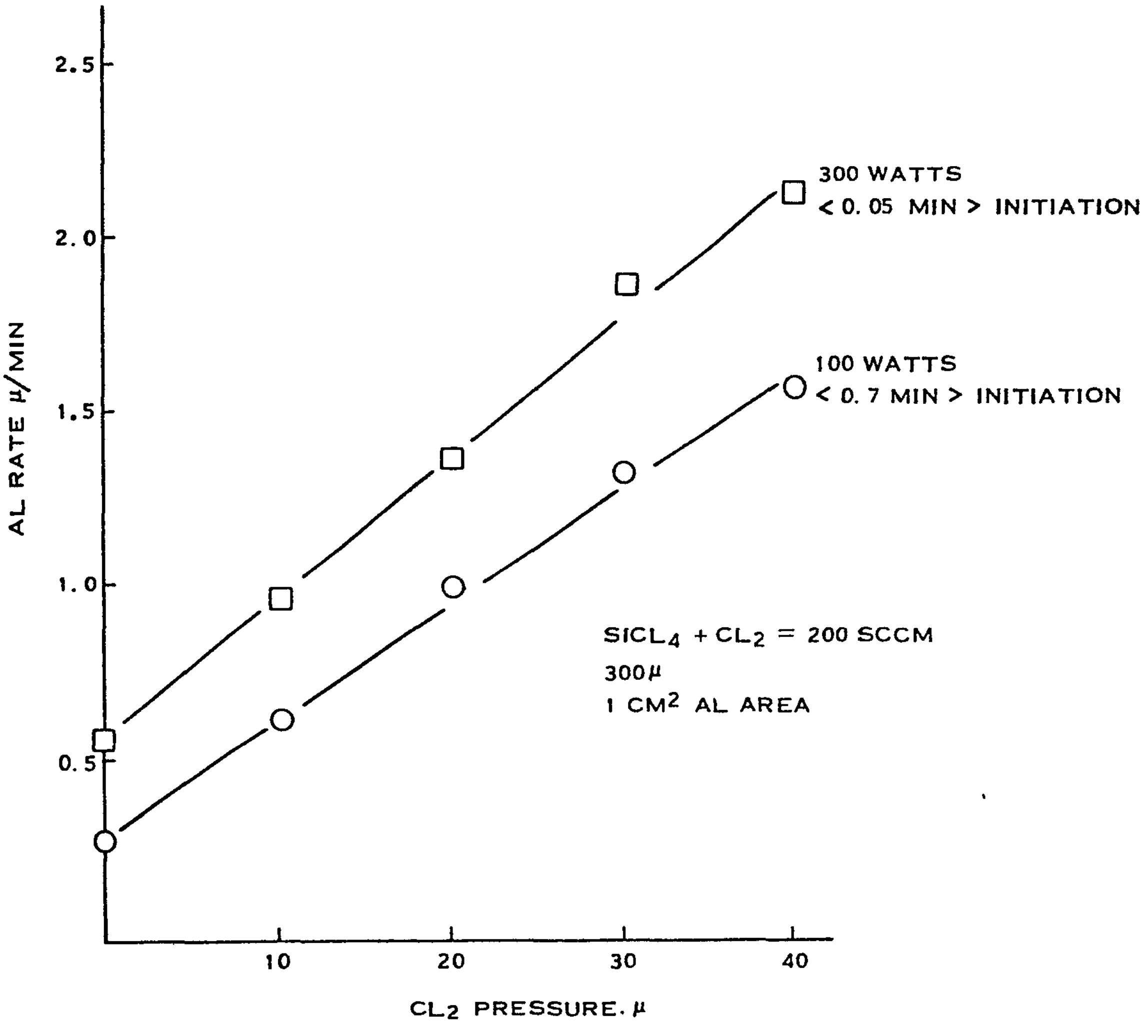


FIG. 9

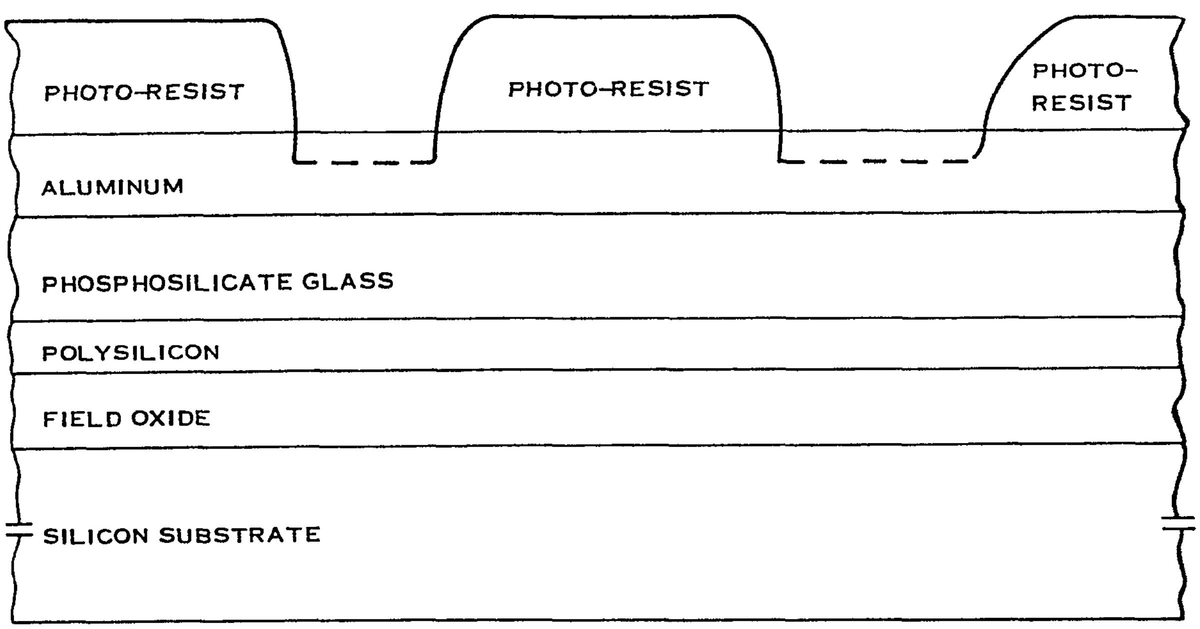


FIG. 10